# NEUE EUROPÄISCHE PATENTSCHRIFT

(11) **EP 0 238 524 B2**
(45) Veröffentlichungstag und Bekanntmachung des Hinweises auf die Entscheidung über den Einspruch: **15.12.1993**
(45) Hinweis auf die Patenterteilung: 02.08.1989
(21) Anmeldenummer: 86905284.5
(22) Anmeldetag: 08.09.1986
(51) Int. Cl.: G01R 15/02, H01F 40/06

(54) **STROMWANDLERANORDNUNG FÜR EINEN STATISCHEN ELEKTRIZITÄTSZÄHLER**
CURRENT TRANSFORMER FOR A STATIC ELECTRICITY COUNTER
AGENCEMENT DE TRANSFORMATEUR DE COURANT POUR UN COMPTEUR D'ELECTRICITE STATIQUE

(30) Priorität: 14.09.1985 DE 3532911; 23.12.1985 DE 3545953; 10.06.1986 DE 3619423
(43) Veröffentlichungstag der Anmeldung: 30.09.1987
(73) Patentinhaber: LGZ LANDIS & GYR ZUG AG, CH-6301 Zug (CH)
(72) Erfinder: FRIEDL, Richard, D-3300 Braunschweig (DE)
(74) Vertreter: Müller, Hans-Jürgen, Dipl.-Ing.
(86) Internationale Anmeldenummer: EP8600515
(87) Internationale Veröffentlichungsnummer: WO8701812

(56) Entgegenhaltungen:
- WO-A-83/01535
- DE-B- 1 079 192
- DE-B- 1 133 817
- JP-A- 5 133 943
- R.W. Pohl: "Elektrizitätslehre, Einführung in die Physik", 2. Band, Springer Verlag Berlin, Göttingen, Heidelberg, 1949, S. 74-83
- W. Schwerdtfeger: "Elektrische Messtechnik, Teil 2, Wechselstromtechnik", C.F. Winter'sche Verlagsbuchhandlung, Leipzig, 1939, S. 8,9,200 und 201
- E. Stirner: "Antennen, Band 3, Messtechnik", Kapitel 7, Messung der Stromverteilung an Antennen, Hüttig Verlag, Heidelberg 1985, ausgeliefert ab 31.1.1985, S. 170,171
- ETZ-A, Band 83, Heft 11, 21. Mai 1962, S. 349-356

## Beschreibung

Die Erfindung betrifft eine Stromwandleranordnung nach dem Oberbegriff des Anspruches 1.

Das Messen großer Ströme zur Ermittlung des Energieverbrauches mittels statischer Elektrizitätszahler erfordert den Einsatz von Stromwandlern, deren Ausgangssignale für die Weiterverarbeitung in elektronischen Meßwerken geeignet sein müssen. Die zu messenden Ströme weisen Beträge von mehr als 100 Ampere auf, welche bis in den Meßbereich von Milliampere mit geringen Linearitätsabweichungen erfaßt werden müssen. Gegenüber Gleichstromanteilen im Meßstrommüssen derartige Anordnungen weitgehend unempfindlich sein. Außerdem soll der Verbrauch an erforderlicher Hilfsenergie zum Betrieb der Anordnung möglichst klein sein.

Weiterhin müssen die in der IEC-Publikation 521 genannten Forderungen, insbesondere die galvanische Trennung bei hoher Isolationsfestigkeit, die Kurzschlußfestigkeit, die Unempfindlichkeit gegen äußere magnetische Störfelder sowie das Einhalten des Frequenzeinflusses erfüllt sein.

Die als magnetischer Spannungsmesser ausgebildete Anordnung nach der DE-B-1 079 192 besteht aus zwei in Reihe geschalteten Sekundärspulen, welche eine Stromschiene umfassen. Die sekundären Teilwicklungen sind an ihren Enden mit magnetischen Material kurzgeschlossen. Hierdurch ergibt sich ein geschlossenem magnetischer Kreis (Rogowski-Spule), welcher sich gegenüber Fremdfeldern astatisch verhält, sofern die Windungsdichte der Teilwicklungen ausreichend groß und die Windungsverteilung gleichmäßig ist. Bei großen Stromdichten im Primärleiter müssen die Sekundärspulen von diesem einen gewissen Abstand haben, um eine einwandfreie Integration der Teilspannungen der unstetig verteilten Wicklung zu ermöglichen.

Die bekannte Stromwandleranordnung ist mit einer elektronischen Integrierstufe ausgerüstet, deren bezüglich ihres Eingangssignals zum Ausgangssignal umgekehrt proportionaler Freguenzgang die proportionale Frequenzabhängigkeitder in der Sekundärwicklung vom Meßstrom induzierten Spannung kompensiert und welche das Einqangssignal zur gegenphasigen Lage ihres Ausgangssignal gegenüber dem zu messenden Strom um einen Phasenwinkel von 90° weiterdreht. Das Meßsignal am Ausgang der Integrierstufe ist durch deren Wirkung unabhängig von der Meßfrequenz und befindet sich in Gegenphase zum Meßstrom bei direkter Proportionalität zwischen den Amplituden.

Bei der bekannten Stromwandleranordnung ist nachteilig, daß die Forderung nach einer weitgehenden Unempfindlichkeit gegenüber äußeren magnetischen Störfeldern durch die Verwendung von magnetischem Material nicht vollkommen erfüllt ist. Weiterhin liefert die bekannte Anordnung sehr kleine Ausgangssignale, da nur eine geringe Kopplung zwischen den Feldern des Primärleiters und der Sekundärspulen besteht. Somit ist dieses Verfahren für die Messung von Stromstärken unterhalb von etwa 1 Kiloampere nicht geeignet.

Aus der WO 83/01535 ist ein aktiver Stromsensor mit primärer Reduzierwicklung bekannt, bei welchem die, Fehlerkompensation mit Hilfe einer Indikatorwicklung derart vorgenommen wird, daß ein Strom mittels eines Verstärkers in der Sekundärwicklung erzeugt wird, der die Induktion im Magnetkern eliminiert. Ein wesentlicher Nachteil dieser Anordnung liegt in der Verwendung von magnetischem Kernmaterial zur Erzeugung einer ausreichenden magnetischen Kopplung, da der magnetische Werkstoff zu erheblichen Fehlern bei Gleichstrokomponenten im Meßstrom führt. Eine Reduzierung der primärseitigen Durchflutung wird durch eine aus zwei Leitern gegensinnig gewickelte Primärwicklung erzielt, um eine Sättigung des Kerns durch Gleichstromdurchflutung zu vermeiden.

Eine Stromwandleranordnung gemäß dem Oberbegriff des Patentanspruchs 1 ist in der JP-U-51 33 943 beschrieben. Dabei stehen die Achsen der Sekundärspulen senkrecht zur Achse der Primärspulen, so daß keine Kompensation inhomogener Fremdfelder gelingt.

Der Erfindung liegt die Aufgabe zugrunde, eine Stromwandleranordnung dieser Gattung dahingehend zu verbessern, daß für einen großen Meßbereich in der Größenordnung von Milliampere bis über 100 Ampere der Einfluß äußerer magnetischer Störfelder weiter verringert wird und ein hohes sekundärseitiges Ausgangssignal bei räumlich kleiner Bauweise sowie gleichzeitiger Verwendung billiger Bauelemente möglich ist.

Die erfindungsgemäße Lösung der Aufgabe ist durch die Merkmale des Anspruches 1 gekennzeichnet. Bei dieser Anordnung weist der Sekundärspulenträger eine vom magnetischen Feld des Primärleiters im wesentlichen unabhängige Permeabilität auf. Die Sekundärwicklung besteht aus zwei in Reihe geschalteten Sekundärspulen, deren Sekundärspulenachsen zueinander parallel verlaufen. Der Windungssinn der Sekundärspulen entspricht dem eines in der Mitte räumlich um 180° abgeknickten Solenoiden. Diese astatische Anordnung der Sekundärspulen führt zu einer Sekundärwicklung, die gegenüber äußeren homogenen magnetischen Störwechselfeldern unabhängig ist, da sich die durch die Störfelder in beiden Sekundär spulen induzierten Teilspannungen gegenseitig aufheben. Während bei der bekannten aus Teilwicklungen bestehenden Sekundärspulen die Teilwicklungen stets zu einem geschlossenen Integrationsweg entsprechend einer Rogowski-Sekundärspule zusammengesetzt sind, erstrecken sich die Sekundärspulen bei der Erfindung zwecks Erzielung kleiner Abmessungen jeweils nur über eine Teillänge von wenigen als 50 % der vom Strom im Primärleiter erzeugten Magnetfeldlinien, so daß kein geschlossenen Integrationsweg gebildet wird. Die zweite Sekundärspule dient dabei in erster Linie der Kompensation des Einflusses von Fremdfeldern. Im Hinblick auf eine möglichst optimale Kompensation weisen die beiden Sekundärspulen geringe räumliche Abmessungen auf und sind möglichst dicht nebeneinander angeordnet.

Die Sekundärspulen können als Zylinder- oder Flachspulen mit zueinander parallelen Sekundärspulenachsen verlaufen, wobei wenigstens eine der beiden Sekundärspulen sich räumlich an einem Ort befindet, an welchem der Primärstrom eine möglich große Feldstärke erzeugt. Die für ein hohes sekundärseitiges Ausgangssignal der Anordnung erforderliche hohe Feldstärke wird durch die Formgebung des Primärleiters zu einer Stromschleife erreicht. Somit erfassen die sekundären Teilspulen das magnetischen Feld des Primärleiters nur örtlich punktuell, wobei die Summe der in den beiden Sekundärspulen induzierten Spannungen dem zu erfassenden Primärstrom proportional ist.

Ein besonderes Merkmal der neuen Stromwandleranordnung ist deren hohe magnetische Kopplung zwischen dem Primärleiter und der Sekundärspule, so daß sich große sekundärseitige Ausgangssignale ergeben, welche die Verwendung der Anordnung für die lineare Erfassung von Strömen mit Stromstärken bis herab zu einigen Milliampere ermöglicht. Dies wird ohne Verwendung von magnetischem Material erreicht. Hierdurch ergibt sich eine räumlich kleine Bauweise, welche eine kostengünstige Herstellung ermöglicht.

Die maximale magnetische Kopplung wird durch einen möglichst kleinen Abstand zwischen der primären Stromschleife und wenigstens einer der Sekundärspulen erreicht. Um den magnetischen Fluß der primären Stromschleife möglichst vollständig zu erfassen, ist die Primärspule praktisch innerhalb der Stromschleife angeordnet.

In einer zweckmäßigen Ausführungsform sind zwei Stromschleifen mit einander entgegengerichteten Wicklungsrichtungen nebeneinander angeordnet, wobei jeweils eine der Stromschleifen mit einer der Sekundärspulen magnetisch verkoppelt ist. Die magnetischen Flüsse dieser beiden Stromschleifen sind hierbei einander entgegengerichtet.

In einer vorteilhaften Ausführungsform sind zwei Stromschleifen in Reihe geschaltet, wobei jede Stromschleife eine Sekundärspule umfaßt. Es ist aber auch möglich, daß zwei Stromschleifen zueinander parallel geschaltet sind und jede Stromschleife eine Sekundärspule umfaßt. Hierbei teilt sich der zu messende Primärstrom auf zwei Windungen auf, so daß bei einem vorzugsweise aus Kupfer gestanzten Primärleiter mit Rechteckquerschnitt Faltungen bei der Überkreuzung der Leiterteile vermieden werden können.

Eine sehr zweckmäßige Ausführungsform ist durch die Merkmale des Anspruches 5 gekennzeichnet. Hierbei ist der Primärleiter um eine Querachse um einen Winkel von 180° gefaltet, so daß der Hin- und Rückleiter in geringem Abstand übereinander liegen. Dieser Abstand kann wenigstens abschnittsweise so gestaltet sein, daß der dadurch entstehende Raum zur Unterbringung der sekundären Wicklung geeignet ist. Bei dieser Ausführungsform wird der magnetische Störfeldeinfluß auf das Meßergebnis praktisch ausgeschaltet. Durch die Form und die kleinen Abmessungen der Anordnung wird in einfacher Weise eine vollautomatische Fertigung ermöglicht.

Vorteilhaft ist es, wenn die Ausnehmungen sich etwa von der Mittelachse bis zum Rand des Flachleiters einander entgegengerichtet erstrecken. Hierdurch wird der in Längsrichtung des primären Flachleiters verlaufende elektrische Strom zur Mitte des Primärleiters umgelenkt, so daß die Strompfade zu einer Schleife geformt werden.

In einer weiteren Ausführungsform ist vorgesehen, daß die gegenüberliegenden Leiterabschnitte des Flachleiters jeweils zwei einander entgegengerichtete und parallel versetzt angeordnete Ausnehmungen aufweisen und dadurch zwei in Längsrichtung des Flachleiters nebeneinander liegende Abschnitte der Stromschleife bilden. Hierbei befinden sich zweckmäßigerweise die Sekundärspulen zwischen den Leiterabschnitten des Flachleiters. Da die Formgebung des Flachleiters zu zwei nebeneinander liegenden Abschnitten der Stromschleife führt, deren Achsen jeweils durch die einander zugekehrten Enden der Ausnehmungen gebildet werden, kann jede Sekundärspule jeweils einer Primärwindung zugeordnet werden, so daß eine optimale Flußverkettung gegeben ist.

Eine weitere vorteilhafte Ausführungsform ergibt sich, wenn die Sekundärspulen in der Bauweise der Planartechnik ein- oder mehrlagig, möglicherweise auch beidseitig als Spiralen auf einem Substrat aufgebracht sind. Dieses plattenförmige Substrat kann zwischen die im Abstand angeordneten Leiterabschnitte eingeschoben werden. Das Substrat mit beiden Sekundärspulen kann auch außerhalb des Raumes zwischen den Leiterabschnitten über den wirksamen Windungsflächen des primären Flachleiters angeordnet sein.

Außerdem ist es moglich, daß das Substrat weitere elektronische Bauteile des Elektrizitätszählers enthält. Dies können beispielsweise die elektronischen Bauelemente der Integrationsstufe und der Multiplizierstufe sein.

Eine weitere Ausführungsform ergibt sich dadurch, daß der eine Leiterabschnitt zwei einander entgegengerichtete, zum Rand des Primärleiters sich auf einer gemeinsamen Achse erstreckende Ausnehmungen aufweist, zu denen parallel eine nicht bis zu den Rändern gehende Ausnehmung auf dem anderen Leiterabschnitt angeordnet ist. Bei dieser Anordnung der Ausnehmungen werden die Strompfade so geführt, daß zwei parallel geschaltete Windungen gebildet werden, welche jeweils mit dem magnetischen Fluß einer Sekundärspule verkettet sind.

Die Erfindung ist anhand in der Zeichnung dargestellte Ausführungssbeispiele nachstehend näher erläutert. Auf die Darstellung der bekannten Integrationsschaltung wurde verzichtet.

Es zeigen:
- Fig. 1:: Eine Stirnansicht von zwei astatisch aufgebauten sekundären Spulen, von denen eine von einem Primärleiter umschlossen ist,
- Fig. 2:: eine Stirnansicht von zwei astatisch aufgebauten Spulen, welche von in Reihe geschalteten Windungen des Primärleiters umschlossen sind,
- Fig. 3:: eine Anordnung der sekundären Spulen nach Fig. 2, jedoch mit parallel geschalteten Windungen des Primärleiters,
- Fig. 4:: die perspektivische Ansicht eines als Flachleiter geformten Primärleiters, bei welchem eine der astatisch aufgebauten sekundären Spulen zwischen gegenüberliegenden Leiterabschnitten des Flachleiters und die andere sekundäre Spule außerhalb des Flachleiters angeordnet sind,
- Fig. 5:: eine perspektivische Ansicht eines Primärleiters in einer gegenüber Fig. 4 veränderten Ausführungsform,
- Fig. 6:: die perspektivische Ansicht der astatisch aufgebauten Spulen der Sekundärwicklung mit einer Grundplatte, welche in den Primärleiter nach Fig. 5 einschiebbar ist,
- Fig. 7:: eine Querschnittsdarstellung der Anordnung nach Fig. 5 und 6 im betriebsmäßigen Zustand in verkleinerter Darstellung,
- Fig. 8:: die perspektivische Darstellung einer gegenüber Fig. 4 und 5 veränderten Ausführungsform des Primärleiters,
- Fig. 9:: eine perspektivische Ansicht astatisch aufgebauter Flachspulen als Sekundärwicklung auf einer Grundplatte, welche in den Primärleiter nach Fig. 8 einschiebbar ist,
- Fig. 10:: eine perspektivische Darstellung eines zur Fig. 8 vergleichbaren Primärleiters mit darin angeordneten Spulen der Sekundärwicklung,
- Fig. 11:: die Draufsicht auf einem aufgeklappten als Flachleiter ausgebildeten Primärleiter,
- Fig. 12:: eine Draufsicht auf den Primärleiter nach Fig. 11 im gefalteten Zustand,
- Fig. 13:: eine Draufsicht auf eine Grundplatte mit astatisch aufgebauten Flachspulen in einer mit Fig. 9 vergleichbaren Bauweise,
- Fig. 14:: eine Draufsicht auf den gefalteten Primärleiter nach Fig. 11 auf die gegenüber Fig. 12 entgegengesetzte Seite und
- Fig. 15:: einen Querschnitt der Anordnung nach Fig. 14.

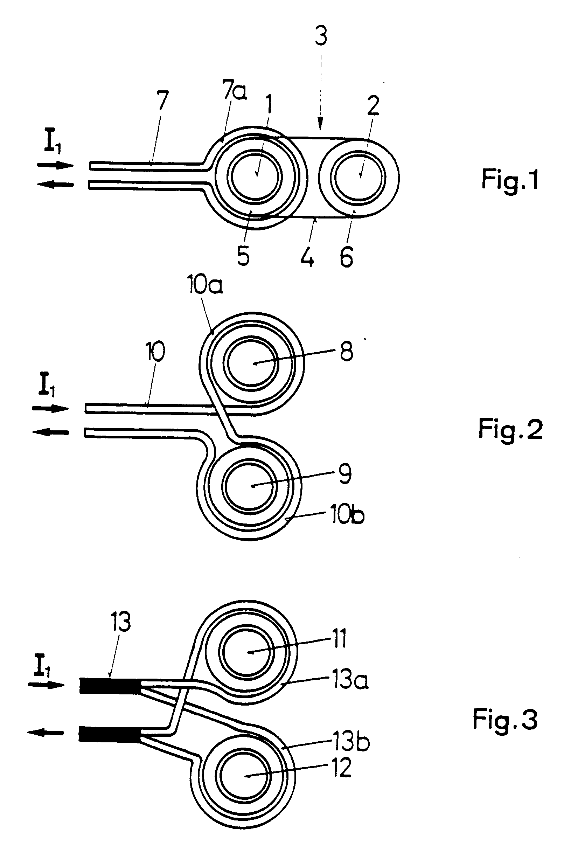

Fig. 1 zeigt zwei im Abstand angeordnete astatisch aufgebaute zylindrische Spulen 1 und 2 einer Sekundärwicklung 3. Die über einen Abstandshalter 4 gehaltenen Spulen 1 und 2 sind geometrisch und elektrisch identisch und verlaufen mit ihren Zylinderachsen parallel zueinander. Die Spulen 1 und 2 sind in einem Isolierzylinder 5 und 6 angeordnet. Die Spule 1 wird von einer Windung 7a des Primärleiters 7 umfaßt, durch welchen der Meßstrom I₁ in Richtung der angegebenen Pfeile fließt. Die in den Spulen 1 und 2 vom magnetischen Feld des im Primärleiter 7 fließenden Wechselstromes induzierten Spannungen addieren sich zu einem dem zu messenden Wechselstrom I₁ proportionalen Signal. Durch homogene äußere Störwechselfelder induzierte Spannungen haben wegen der astatischen Anordnung der Spulen 1 und 2 unterschiedliche Vorzeichen und heben sich in der Summe auf. Durch diese Maßnahme wird der Einfluß äußerer magnetischer Wechselfelder auf die richtige Funktion der Stromwandleranordnung weitgehend unterdrückt. Durch die Spulen umgebendes magnetisches Abschirmmaterial kann der Fremdfeldeinfluß weiter reduziert werden.

In Fig. 2 entsprechen die Spulen 8 und 9 den in Fig. 1 dargestellten Spulen. Die sekundären Spulen 8 und 9 werden nacheinander vom gemeinsamen Primärleiter 10 umfaßt. Diese Reihenschaltung der primären Windungen 10a und 10b führt zu einem gegenüber der Anordnung nach Fig. 1 vergrößerten Meßsignal.

In Fig. 3 entsprechen die Spulen 11 und 12 den Spulen 8 und 9 in Fig. 2. Der Primärleiter 13 ist auf zwei Teilleiter verzweigt, die jeweils zu einer die Spule 11 bzw. 12 umschließende Windung 13a bzw. 13b geformt sind. Der Strom I₁ wird auf die Teilleiter mit den Windungen 13a und 13b verzweigt, wobei die Summe der in den Spulen 11 und 12 induzierten Spannungen dem zu messenden Strom I₁ proportional ist. Der Vorteil der Anordnung nach Fig. 3 gegenüber der Ausführung nach Fig. 2 besteht darin, daß bei dem vorzugsweite aus Kupfer gestanzten Primärleiter 13 mit Rechteck-Querschnitt (Flachleiter) Faltungen bei der Überkreuzung der Leiterteile vermieden werden können.

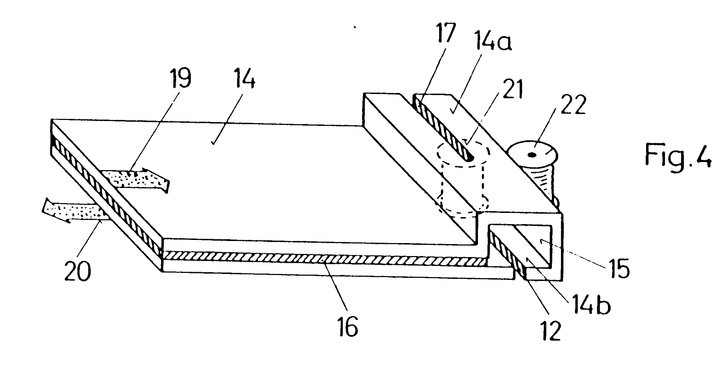

In der Ausführungsform nach Fig. 4 ist ein Primärleiter 14 als Flachleiter mit rechteckigem Querschnitt ausgebildet, welcher so gefaltet ist, daß gegenüberliegende Leiterabschnitte 14a und 14b einen quaderförmigen Hohlraum 15 ergeben. Außerhalb des Hohraumes 15 sind gegenüberliegende Abschnitte des Primärleiters 14 durch eine Isolierschicht 16 voneinander getrennt. Der Leiterabschnitt 14a ist mit einer von etwa der Mitte zum Rand sich ertreckenden schlitzförmigen Ausnehmung 17 ausgerüstet. Eine in entgegengesetzte Richtung sich bis zum Rand erstreckende Ausnehmung 18 ist auf dem gegenüberliegenden Leiterabschnitt 14b vorgesehen. Die Ausnehmungen 17 und 18 beeinflussen die geometrische Lage der Strompfade des durch die Pfeile 19 und 20 dargestellten zu messenden Stromes derart, daß für den Primärstrom eine Windung geformt wird. Im magnetischen Feld dieser Windung ist die gestrichelt dargestellte sekundäre Spule 21 angeordnet. Eine zweite sekundäre Spule 22 befindet sich zur Kompensation magnetischer Fremdfelder außerhalb des Primärleiters.

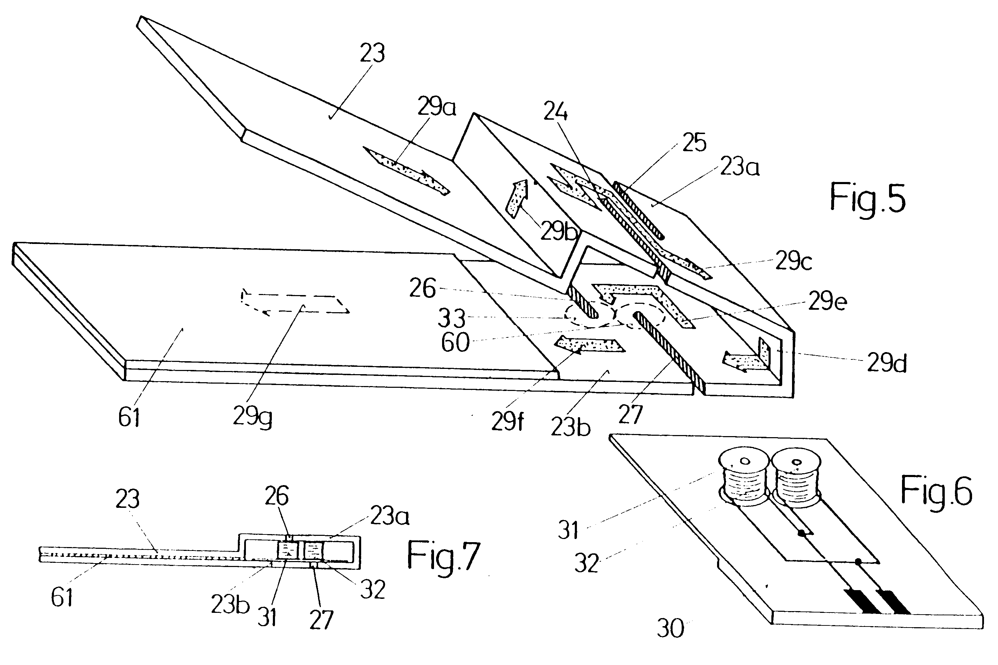

Der in Fig. 5, dargestellte Primärleiter 23 unterscheidet sich von der Ausführungsform nach Fig. 4 dadurch, daß in den gegenüberliegenden Leitungsabschnitten 23a und 23b jeweils zwei einander entgegengerichtete schlitzförmige Ausnehmungen 24 und 25 bzw. 26 und 27 vorgesehen sind. Die seitlich offenen Ausnehmungen 24 bis 27 verlaufen jeweils etwa bis zur Mitte der Leiterabschnitte 23a und 23b. Die Ausnehmungen 24 und 26 befinden sich in derselben Ebene senkrecht zum Primärleiter 23, wenn dieser im betriebsmäßigen Zustand um 180° gefaltet ist, also die Leiterabschnitte 23a und 23b zueinander parallel verlaufen. In gleicher Weise sind die Ausnehmungen 25 und 27 in einer gemeinsamen Ebene senkrecht zum Primärleiter 23 angeordnet.

Durch die obige Ausbildung der Ausnehmungen 24 bis 27 verläuft der Primärstrom auf Strompfaden, die durch die Pfeile 29a bis 29g gekennzeichnet sind. Hierdurch werden in den Ebenen der Leiterabschnitte 23a und 23b in Reihe geschaltete primäre Windungen gebildet, in deren magnetischem Feld sekundäre Spulen angeordnet werden können.

Auf der in Fig. 6 dargestellten Grundplatte 30 befinden sich zwei astatisch angeordnete sekundäre Spulen 31 und 32. Im betriebsmäßigen Zustand befindet sich die Grundplatte 30 mit den Spulen 31 und 32 zwischen den Leiterabschnitten 23a und 23b des Primärleiters nach Fig. 5. Die Lage der Spule 31 in Fig. 6 ist auf dem Leitungsabschnitte 23b in Fig. 5 durch den gestrichelten Kreis 33 gekennzeichnet. Entsprechend befindet sich die Spule 32 in Fig. 6 in einem durch den in Fig. 5 gestrichelten Kreis 60 dargestellten Bereich.

Fig. 7 zeigt die Stromwandleranordnung mit dem primärseitigen Teil nach Fig. 5 und dem sekundärseitigen Teil nach Fig. 6 im betriebsmäßigen Zustand. Hierbei sind die oberen und unteren Abschnitte des Primärleiters 23 durch eine Isolierschicht 61 voneinander getrennt.

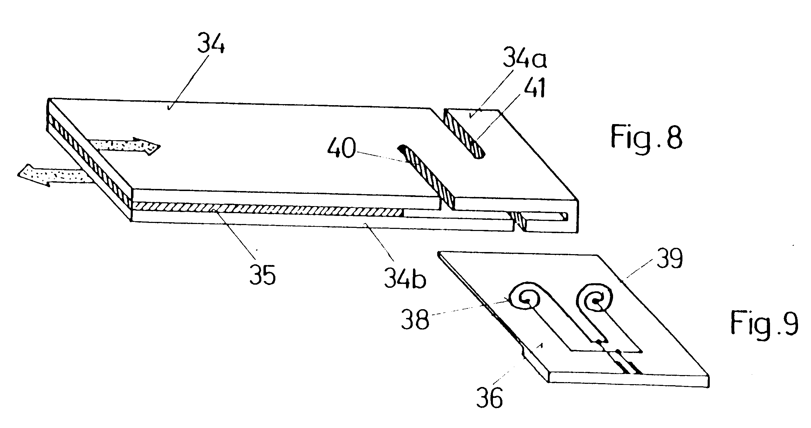

Der Primärleiter 34 in Fig. 8 ist mit dem Primärleiter 23 in Fig. 5 vergleichbar. Lediglich der Abstand zwischen dem oberen Leiterabschnitt 34a und dem unteren Leiterabschnitt 34b ist geringer und entspricht der Dicke der Isolierschicht 35.

Die in Fig. 9 dargestellte Grundplatte 36 mit den darauf angeordneten sekundären Spulen 38 und 39 befindet sich im betriebsmäßigen Zustand der Stromwandleranordnung zwischen den Leiterabschnitten 34a und 34b des Primärleiters 34 nach Fig. 8. Die Spulen 38 und 39 in Fig. 9 sind spiralförmigaufgebaut und in Planartechnik hergestellt, so daß der geringe Raum zwischen den Leiterabschnitten 34a und 34b nach Fig. 8 ausreicht. Im Betriebszustand befindet sich der Mittelpunkt der Spule 38 etwa am mittigen Ende der schlitzförmigen Ausnehmung 40 in Fig. 8. Entsprechend sind der Mittelpunkt der Spule 39 und das mittige Ende der Ausnehmung 41 etwa deckungsgleich angeordnet.

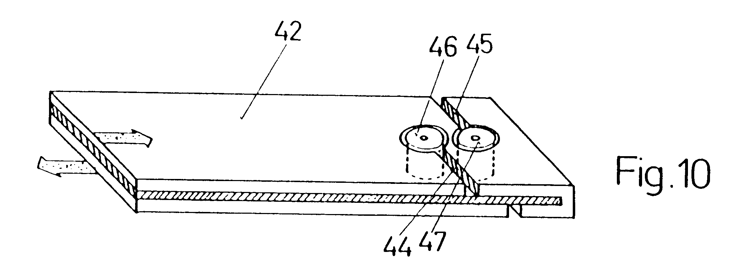

In Fig. 10 ist ein Primärleiter 42 wiedergegeben, welcher im wesentlichen dem Primärleiter 34 in Fig. 8 entspricht. Allerdings sind die Ausnehmungen 44 und 45 an ihrem zur Mitte des Primärleiters 42 gerichteten Ende als Löcher ausgebildet, in denen astatisch aufgebaute sekundäre Spulen 46 und 47 gelagert sind.

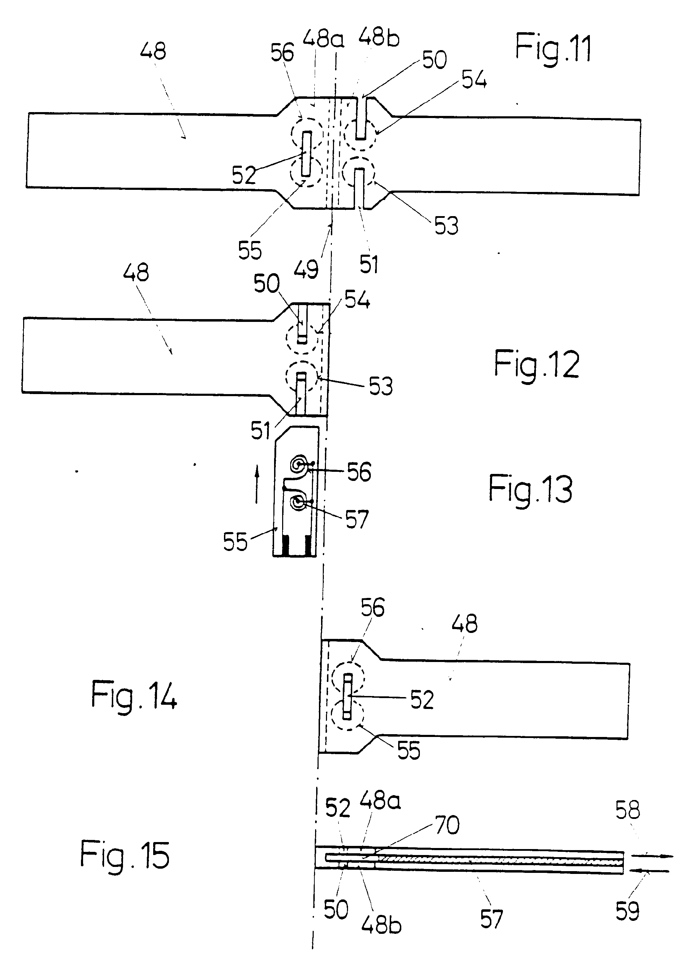

Bei der Ausführungsform nach Fig. 11 ist ein Primärleiter 48 offen, also vor der Faltung um eine Linie 49, dargestellt. Im gefalteten Zustand befindet sich ein Leiterabschnitt 48a über einem Leiterabschnitt 48b. Der Leiterabschnitt 48b zeigt Ausnehmungen 50 und 51, welche einander entgegengerichtet sind und auf einer gemeinsamen Längsachse parallel zur Faltungslinie 49 verlaufen. Auf dem Leiterabschnitt 48a ist eine Ausnehmung 52 vorgesehen, welche nur im mittigen Bereich des Leiterabschnittes 48 verläuft und zur Faltungslinie 49 den gleichen Abstand aufweist wie die Ausnehmungen 50 und 51. Die Lageorte für die sekundären Spulen sind durch die gestrichelten Kreise 53 und 54 wiedergegeben. Dazu spiegelsymmetrisch zur Faltungslinie 49 befinden sich für die sekundären Spulen die entsprechenden Grundflächen 55 und 56.

Fig. 12 zeigt den Primärleiter 48 nach Fig. 11 in zusammengefalteter Form, so daß die Leiterabschnitte 48a und 48b übereinanderliegen. Entsprechend sind nur die Ausnehmungen 50 und 51 mit den Orten für die sekundären Spulen, welche durch Kreise 53 und 54 angedeutet sind.

In Fig. 13 sind die auf einer Grundplatte 55 befestigten sekundären Spulen 56 und 57 in astatischer Bauweise dargestellt. Diese prinzipiell der Fig. 9 entsprechenden Anordnung unterscheidet sich von dieser im wesentlichen dadurch, daß die Spulen 56 und 57 in Fig. 13 von der Faltungslinie 49 den gleichen Abstand aufweisen. Die Spulen 56 und 57 können ebenfalls in Planartechnik hergestellt sein. Um beide Spulen dem entsprechenden primären magnetischen Fluß auszusetzen, können sie auch außerhalb des Raumes zwischen den gefalteten Leiterabschnitten 48a und 48b nach Fig. 11 angeordnet sein, sofern die magnetische Kopplung für ein hohes Ausgangssignal ausreicht. Auch für diesen Fall sind die in den Fig. 11 und 12 dargestellten Kreise die entsprechenden Orte für die sekundären Spulen.

Fig. 14 zeigt den Primärleiter 48 nach Fig. 11 in zusammengefaltetem Zustand von der gegenüberliegenden Seite im Vergleich zu Fig. 12. Entsprechend ist nur die mittige Ausnehmung 52 erkennbar.

Auch in Fig. 15 ist der Primärleiter 48 in zusammengefaltetem Zustand erkennbar, wobei der Abstand zwischen dem oberen Leiterabschnitt 48a und dem unteren Leiterabschnitt 48b durch eine Isolierschich 57 bestimmt ist. Die Richtung des zumessenden primären Stromes durch die Pfeile 58 und 59 gekennzeichnet. In dem Raum 70 wird die Grundplatte 55 nach Fig. 13 eingeschoben.

## Patentansprüche

1. Stromwandleranordnung, insbesondere für einen statischen Elektrizitätszähler, mit einem den zu messenden Wechselstrom führenden Primärleiter (7, 10, 13, 14, 23, 34, 42, 48) sowie mit einer aus mindestens zwei in Reihe geschalteten und astatisch aufgebauten, elektrisch identischen Spulen bestehenden Sekundärwicklung, die mit dem Primärleiter ohne magnetische Werkstoffe gekoppelt ist,
**dadurch gekennzeichnet**,
daß zur Erzeugung einer maximalen magnetischen Feldstärke der Primärleiter (7, 10, 13, 14, 23, 34, 42, 48) zu wenigstens einer Stromschleife (7a, 10, 10b, 13a, 13b, 29c, 29e) geformt ist, daß wenigstens eine der Sekundärspulen (1, 8, 11, 12, 21, 22, 31, 32, 38, 39, 46, 47, 56, 57) zur maximalen magnetischen Kopplung in möglichst kleinem Abstand zur entsprechenden Stromschleife (7a, 10, 10b, 13a, 13b, 29c, 29e) und praktisch innerhalb dieser angeordnet ist, daß sich die Sekundärspulen (1, 8, 11, 12, 21, 22, 31, 32, 38, 39, 46, 47, 56, 57) in ihrer axialen Richtung über eine möglichst kleine Teillänge der vom Strom im Primärleiter erzeugten Magnetfeldlinien erstrecken, daß die Sekundärspulen (1, 8, 11, 12, 21, 22, 31, 32, 38, 39, 46, 47, 56, 57) zur optimalen Fremdfeldkompensation möglichst nahe nebeneinander angeordnet sind und daß zur Erzeugung eines frequenzunabhängigen Meßsignals eine nachgeschaltete elektronische Integrierstufe an den Ausgang der Sekundärspulen (8, 9, 11, 12) angelegt ist.

2. Stromwandleranordnung nach Anspruch 1,
**dadurch gekennzeichnet**,
daß zwei Stromschleifen (10a, 10b, 13a, 13b) mit einander entgegengerichteten Wicklungsrichtungen nebeneinander angeordnet sind und jeweils eine der Stromschleifen mit einer der Sekundärspulen (8, 9, 11, 12) magnetisch verkoppelt ist.

3. Stromwandleranordnung nach Anpruch 1 oder 2, dadurch gekennzeichnet, daß zwei Stromschleifen (10a, 10b) in Reihe geschaltet sind und jede Stromschleife (10a, 10b) eine Sekundärspule (8, 9) umfaßt.

4. Stromwandleranordnung nach Anspruch 1 oder 2, dadurch gekennzeichnet, daß zwei Stromschleifen (13a, 13b) zueinander parallel geschaltet sind und jede Stromschleife (13a, 13b) eine Sekundärspule (11, 12) umfaßt.

5. Stromwandleranordnung nach einem der vorhergehenden, Ansprüche, dadurch gekennzeichnet, daß der Primärleiter (14, 23, 34, 42, 48) als gefalteter Flachleiter mit einander gegenüberliegenden Leiterabschnitten (14a, 14b, 23a, 23b, 34a, 34b, 48a, 48b) ausgebildet ist, welche jeweils durch wenigstens eine Ausnehmung (17, 18, 25 bis 28, 50 bis 52) wenigstens einen Abschnitt der Stromschleife (29c, 29e) in der Ebene des Flachleiters bilden.

6. Stromwandleranordnung nach Anspruch 5, dadurch gekennzeichnet, daß sich die Ausnehmungen (17, 18, 22 bis 28) etwa von der Mittelachse bis zum Rand des Flachleiters einander entgegengerichtet erstrecken.

7. Stromwandleranordnung nach Anspruch 6, dadurch gekennzeichnet, daß die gegenüberliegenden Leiterabschnitte des Flachleiters jeweils zwei einander entgegengerichtete und parallel versetzt angeordnete Ausnehmungen (25 bis 28) aufweisen und dadurch zwei in Längsrichtung des Flachleiters (23) nebeneinander liegende Abschnitte der Stromschleife (29c, 29e) bilden.

8. Stromwandleranordnung nach einem der Ansprüche 5 bis 7, dadurch gekennzeichnet, daß die Sekundärspulen zwischen den Leiterabschnitten des Flachleiters angeordnet sind.

9. Stromwandleranordnung nach Anspruch 7 oder 8, dadurch gekennzeichnet, daß die Sekundärspulen (38, 39) in der Bauweise der Planartechnik ein- oder mehrlagig als Spiralen auf einem Substrat aufgebracht sind.

10. Stromwandleranordnung nach Anspruch 5, 8 oder 9 dadurch gekennzeichnet, daß der eine Leiterabschnitt (48b) zwei einander entgegengerichtete, zum Rand des Flachleiters (48) sich auf einer gemeinsamen Achse erstreckende Ausnehmungen (50, 51) aufweist, zu denen parallel eine nicht bis zu den Rändern gehende Ausnehmung (52) auf dem anderen Leiterabschnitt (48a) angeordnet ist.

## Claims

1. A current transformer arrangement, in particular for a static electricity meter, comprising a primary conductor (7, 10, 13, 14, 23, 34, 42, 48) carrying the alternating current to be measured, and a secondary winding which comprises at least two series-connected electrically identical coils of an astatic configuration and which is coupled to the primary conductor without magnetic materials, characterised in that to produce a maximum magnetic field strength the primary conductor (7, 10, 13, 14, 23, 34, 42, 48) is formed into at least one current loop (7a, 10, 10b, 13a, 13b, 29c, 29e), that at least one of the secondary coils (1, 8, 11, 12, 21, 22, 31, 32, 38, 39, 46, 47, 56, 57), for maximum magnetic coupling, is arranged at the smallest possible spacing relative to the corresponding current loop (7a, 10, 10b, 13a, 13b, 29c, 29e) and practically within same, that the secondary coils (1, 8, 11, 12, 21, 22, 31, 32, 38, 39, 46, 47, 56, 57) extend in their axial direction over a smallest possible part of the length of the magnetic field lines produced by the current in the primary conductor, that the secondary coils (1, 8, 11, 12, 21, 22, 31, 32, 38, 39, 46, 47, 56, 57) are arranged in as closely adjacent juxtaposed relationship as possible for optimum external field compensation, and that to produce a measurement signal which is independent of frequency an electronic integration stage on the output side is applied to the output of the secondary coils (8, 9, 11, 12).

2. A current transformer arrangement according to claim 1 characterised in that two current loops (10a, 10b, 13a, 13b) with mutually oppositely directed winding directions are arranged side-by-side and a respective one of the current loops is magnetically coupled to one of the secondary coils (8, 9, 11, 12).

3. A current transformer arrangement according to claim 1 or claim 2 characterised in that two current loops (10a, 10b) are connected in series and each current loop (10a, 10b) embraces a secondary coil (8, 9).

4. A current transformer arrangement according to claim 1 or claim 2 characterised in that two current loops (13a, 13b) are connected in parallel with each other and each current loop (13a, 13b) embraces a secondary coil (11, 12).

5. A current transformer arrangement according to one of the preceding claims characterised in that the primary conductor (14, 23, 34, 42, 48) is in the form of a folded flat conductor with mutually oppositely disposed conductor portions (14a, 14b, 23a, 23b, 34a, 34b, 48a, 48b) which, by means of at least one opening (17, 18, 25 to 28, 50 to 52), each form at least one portion of the current loop (29c, 29e) in the plane of the flat conductor.

6. A current transformer arrangement according to claim 5 characterised in that the openings (17, 18, 22 to 28) extend in mutually opposite directions approximately from the centre line to the edge of the flat conductor.

7. A current transformer arrangement according to claim 6 characterised in that the oppositely disposed conductor portions of the flat conductor each have two mutually oppositely directed openings (25 to 28) which are arranged in parallel displaced relationship and thereby form two portions of the current loop (29c, 29e) which are disposed side-by-side in the longitudinal direction of the flat conductor (23).

8. A current transformer arrangement according to one of claims 5 to 7 characterised in that the secondary coils are arranged between the conductor portions of the flat conductor.

9. A current transformer arrangement according to claim 7 or claim 8 characterised in that the secondary coils (38, 39), being produced by the planar technique, are disposed in one or more layers in the form of spirals on a substrate.

10. A current transformer arrangement according to claim 5, claim 8 or claim 9 characterised in that the one conductor portion (48b) has two mutually oppositely directed openings (50, 51) which extend to the edge of the flat conductor (48) on a common axis and arranged in parallel therewith on the other conductor portion (48a) is an opening (52) which does not go to the edges.

## Revendications

1. Dispositif formant transformateur d'intensité, notamment pour un compteur statique d'électricité, comportant un conducteur primaire (7, 10, 13, 14, 23, 34, 42, 48), véhiculant le courant alternatif à mesurer, ainsi qu'un enroulement secondaire, qui est constitué par au moins deux bobines identiques du point de vue électrique, branchées en série et installées selon un montage astatique et qui est accouplé au conducteur primaire sans aucun matériau magnétique,
caractérisé par le fait
que, pour la production d'une intensité de champ magnétique maximale, le conducteur primaire (7, 10, 13, 14, 23, 34, 32, 48) est agencé de manière à former au moins une boucle de courant (7a, 10, 10b, 13a, 13b, 29c, 29e), qu'au moins l'une des bobines secondaires (1, 8, 11, 12, 21, 22, 31, 32, 38, 39, 46, 47, 56, 57) est disposée, en vue de l'obtention du couplage magnétique maximum, à une distance aussi faible que possible de la boucle de courant correspondante (7a, 10, 10b, 13a, 13b, 29c, 29e) et pratiquement à l'intérieur de cette boucle, que les bobines secondaires (1, 8, 11, 12, 21, 22, 31, 32, 38, 39, 46, 47, 56, 57) s'étendent, dans leur direction axiale, sur une longueur partielle aussi faible que possible des lignes de champ magnétique produites par le courant dans le conducteur primaire, que les bobines secondaires (1, 8, 11, 12, 21, 22, 31, 32, 38, 39, 46, 47, 56, 57) sont disposées de manière à être aussi proches que possible les unes des autres afin de fournir une compensation optimale des champs étrangers, et que pour l'obtention d'un signal de mesure indépendant de la fréquence, un étage intégrateur électronique, branché en aval, est raccordé à la sortie des bobines secondaires (8, 9, 11, 12).

2. Dispositif formant transformateur d'intensité selon la revendication 1, caractérisé en ce que deux boucles de courant (10a, 10b, 13a, 13b), dans lesquelles les sens d'enroulement sont réciproquement opposés, sont disposées côte-à-côte et que respectivement l'une des boucles de courant est couplée magnétiquement à l'une des bobines secondaires (8, 9, 11, 12).

3. Dispositif formant transformateur d'intensité selon la revendication 1 ou 2, caractérisé en ce que deux boucles de courant (10a,10b) sont branchées en série et que chaque boucle de courant (10a,10b) enserre une bobine secondaire (8,9).

4. Dispositif formant transformateur d'intensité selon la revendication 1 ou 2, caractérisé en ce que deux boucles de courant (13a,13b) sont branchées en parallèle et que chaque boucle de courant (13a,13b) enserre une bobine secondaire (11,12).

5. Dispositif formant transformateur d'intensité selon l'une des revendications précédentes, caractérisé en ce que le conducteur primaire (14,23,34,42,48) est réalisé sous la forme d'un conducteur plat replié comportant des sections (14a,14b,23a,23b,34a,34b,48a,48b), qui sont situées en vis-à-vis les unes des autres et forment, respectivement grâce à au moins un évidement (17,18,25 à 28, 50 à 52), au moins une section de la boucle de courant (29c,29e) dans le plan du conducteur plat.

6. Dispositif formant transformateur d'intensité selon la revendication 5, caractérisé en ce que les évidements (17,18,22 à 28) s'étendent approximativement depuis l'axe médian jusqu'au bord du conducteur plat, en des sens réciproquement opposés.

7. Dispositif formant transformateur d'intensité selon la revendication 6, caractérisé en ce que les sections, situées en vis-à-vis, du conducteur plat comportent respectivement deux évidements (25 à 28), dirigés en des sens opposés et décalés parallèlement entre eux, et forment, de ce fait, deux sections, situées côte-à-côte dans la direction longitudinale du conducteur plat (23), des boucles de courant (29c,29e).

8. Dispositif formant transformateur d'intensité selon l'une des revendications 5 à 7, caractérisé en ce que les bobines secondaires sont disposées entre les sections du conducteur plat.

9. Dispositif formant transformateur d'intensité selon la revendication 7 ou 8, caractérisé en ce que les bobines secondaires (38,39) sont disposées, selon le mode de réalisation de la technique planar, sur une ou plusieurs couches, sous la forme de spirales sur un substrat.

10. Dispositif formant transformateur d'intensité selon la revendication 5,8 ou 9, caractérisé en ce qu'une section de conducteur (48b) comporte deux évidements (50, 51), qui sont dirigés en des sens opposés et s'étendent jusqu'au bord du conducteur plat (48), sur un axe commun, et en parallèle avec lesquels se trouve disposé un évidement (52), qui ne s'étend pas jusqu'au bord, sur l'autre section de conducteur (48a).
